# EUROPÄISCHE PATENTSCHRIFT

(11) **EP 2 299 582 B1**
(45) Veröffentlichungstag und Bekanntmachung des Hinweises auf die Patenterteilung: **11.03.2015**
(21) Anmeldenummer: 09170740.6
(22) Anmeldetag: 18.09.2009
(51) Int. Cl.: H02M 7/00, H05K 7/20

(54) **Wechselrichter mit einem Gehäuse und darin angeordneten elektrischen und elektronischen Bauteilen**
Inverter with a housing and electric and electronic components assembled within same
Onduleur doté d'un boîtier et composants électriques et électroniques agencés dedans

(43) Veröffentlichungstag der Anmeldung: 23.03.2011
(73) Patentinhaber: SMA Solar Technology AG, 34266 Niestetal (DE)
(72) Erfinder: Hobein, Thorsten, 34233 Fuldatal (DE); Gebert, Bernd, 34266 Niestetal (DE); Bethke, Lars, 37085 Göttingen (DE)
(74) Vertreter: REHBERG HÜPPE + PARTNER

(56) Entgegenhaltungen:
- EP-A- 1 996 004
- DE-A1-102007 005 436
- DE-U1- 9 320 825

## Beschreibung

### TECHNISCHES GEBIET DER ERFINDUNG

Die Erfindung bezieht sich auf einen Wechselrichter zur Einspeisung elektrischer Energie von einer Gleichstromquelle in ein Wechselstromnetz, wobei der Wechselrichter ein Gehäuse und in dem Gehäuse angeordnete elektrische und elektronische Bauteile sowie die weiteren Merkmale des Oberbegriffs des unabhängigen Patentanspruchs 1 aufweist.

Der Wechselrichter kann insbesondere zur Einspeisung von elektrischer Energie von einer Windkraftanlage oder einer Photovoltaikanlage in ein öffentliches Stromnetz oder ein Inselnetz vorgesehen sein. Dabei kann der Wechselrichter speziell für eine Verwendung im Hausbereich, d. h. innerhalb eines Hauses, wie beispielsweise innerhalb eines Wohnhauses, vorgesehen sein. Dies schließt Verwendungen des Wechselrichters an anderer Stelle aber nicht aus.

### STAND DER TECHNIK

Die elektrischen und elektronischen Bauteile eines Wechselrichters generieren im Betrieb des Wechselrichters Abwärme, die abgeführt werden muss, um ein Überhitzen und damit eine Zerstörung insbesondere von elektronischen Bauteilen auf Halbleiterbasis und damit des gesamten Wechselrichters zu verhindern. Ein Wechselrichter könnte seinen Betrieb bei drohender Überhitzung auch einstellen. In diesem Fall würde jedoch die zur Verfügung stehende elektrische Energie von der Gleichstromquelle nicht in das Wechselstromnetz eingespeist und ginge somit verloren.

Es ist grundsätzlich bekannt, die in einem Gehäuse angeordneten elektrischen und elektronischen Bauteile eines Geräts mit einem Gebläse zu kühlen, das Umgebungsluft als Kühlluft in das Gehäuse einsaugt. Dies ist jedoch einerseits mit dem Nachteil verbunden, dass mit der angesaugten Luft auch Verunreinigungen in das Gehäuse gelangen, die sich dort ablagern und den gewünschten Betrieb der Vorrichtung gefährden können. Außerdem muss, damit die Kühlluft alle relevanten elektronischen und elektrischen Bauteile erreicht, das Gehäuse vergleichsweise groß bemessen werden, damit ausreichende freie Strömungsquerschnitte für die Kühlluft auf ihrem Weg zu den elektrischen und elektronischen Bauteilen verbleiben.

Es ist daher für Wechselrichter zur Einspeisung elektrischer Energie von einer dezentralen Gleichstromquelle in ein Wechselstromnetz bekannt, deren elektrische und elektronische Bauteile ausschließlich über die Außenflächen eines sie umschließenden Gehäuses und davon ausgebildeten Kühlrippen zu kühlen, wobei diese Kühlrippen an der Rückseite des Gehäuses konzentriert und von einem Gebläse mit Umgebungsluft angeblasen werden können, um die Kühlleistung zu verbessern. Besonders viel Abwärme entwickelnde Bauteile werden bei derartigen bekannten Wechselrichtern auch an und nicht in dem Gehäuse angeordnet, so dass sie von der angeblasenen Umgebungsluft direkt beaufschlagt werden. Eine Schutzfunktion für diese Bauteile entwickelt das Gehäuse jedoch nicht.

Auf der Intersolar 2008 vom 12. bis zum 14. Juni 2008 in München hat die Anmelderin eine Designstudie für das Gehäuse eines Wechselrichters zur Einspeisung elektrischer Energie von einer Gleichstromquelle in ein Wechselstromnetzausgestellt, wobei mittig über die Rückseite des Gehäuses des Wechselrichters ein Kühlluftkanal mit darin angeordneten in der Längsrichtung des Kühlluftkanals ausgerichteten Kühlrippen verlief. Die Designstudie betraf das Äußere, nicht das Innere des Gehäuses und war insgesamt nur ein massiver Körper aus Hartschaum. Bei der Designstudie wies das Gehäuse an seiner Rückseite einen mittig und vertikal verlaufenden Kühlluftkanal auf, in dessen oberem Bereich in der Längsrichtung des Kanals ausgerichtete Kühlrippen verliefen. Dabei war das Gehäuse von so geringen seitlichen Abmessungen, dass es zwischen den Ständern einer aus beplankten Ständern aufgebauten Hauswand, wie sie in Nordamerika üblich ist, Platz gefunden hätte. Auch die Tiefe dieses Gehäuses ging nur wenig über die übliche Tiefe derartiger Ständer von 10 cm (4 Zoll) hinaus. Zu dem Innenaufbau des Wechselrichters wurden im Zusammenhang mit der Designstudie keine Angaben gemacht. Insbesondere blieb offen, wie es bei derart kompakten Abmessungen des Gehäuses möglich ist, hierin die notwendigen elektrischen und elektronischen Bestandteile eines Wechselrichters unterzubringen und dennoch für deren ausreichende Kühlung im Betrieb zu sorgen.

Ein Wechselrichter mit den Merkmalen des Oberbegriffs des unabhängigen Patentanspruchs 1 ist aus der DE 93 20 825 U1 bekannt. Das Gehäuse dieses Wechselrichters ist ein Druckgussgehäuse. An der Rückwand des Druckgussgehäuses ist ein Kühlkanal angeordnet. In dem Kühlkanal sind in seiner Längsrichtung ausgerichtete Kühlrippen vorgesehen. In den Kühlkanal ragen Aufnahmevorrichtungen für zu kühlende Bauelemente, beispielsweise für Kondensatoren eines Zwischenkreises des Wechselrichters hinein. Leistungskomponenten werden auf die Innenseite der Außenwand montiert, die mit ihrer Außenseite den Grund des Kühlkanals ausbildet. Eine Hauptplatine mit den Kondensatoren wird mit ihrer Bauelementeseite in die Öffnung des Gehäuses gesteckt und dabei mittels der Kondensatoren und von Leistungsanschlussklemmen im Gehäuse fixiert und gehalten.

Die EP 1 996 004 A1 offenbart ein Wechselrichtergehäuse, das im Boden mindestens eine Vertiefung zur Aufnahme von wärmeabgebenden elektrischen Bauelementen, insbesondere von Wickelgütern, aufweist. An der Rückseite des Gehäuses sind sowohl im Bereich der Vertiefungen als auch in einem dazwischenliegenden Bereich mit Kühlrippen vorgesehen. Die Vertiefungen sind durch wärmedämmende Schottbleche gegenüber dem weiteren Innenraum des Gehäuses abdeckbar.

Aus der DE 10 2007 005 436 A1 ist ein Trägermodul für einen Wechselrichter bekannt, das ein Gehäuseelement mit einer zur Vorderseite offenen Aufnehmung zur Aufnahme eines einzelnen Wechselrichters aufweist. Solche Trägermodule können in einer größeren Anzahl übereinander, nebeneinander oder rückseitig gegeneinander angeordnet und miteinander verbunden werden, um z. B. eine zentrale Wechselrichtereinheit für große Photovoltaikanlagen aufzubauen.

### AUFGABE DER ERFINDUNG

Der Erfindung liegt die Aufgabe zugrunde, einen Wechselrichter mit den Merkmalen des Oberbegriffs des unabhängigen Patentanspruchs 1 aufzuzeigen, bei dem es tatsächlich gelingt, die für eine Einspeiseleistung im Bereich mehrerer Kilowatt erforderlichen elektrischen und elektronischen Bauteile in einem sehr kompakten Gehäuse unterzubringen und dennoch die im Betrieb des Wechselrichters unvermeidbar anfallende Abwärme dieser elektrischen und elektronischen Bauteile zuverlässig abzuführen.

### LÖSUNG

Erfindungsgemäß wird diese Aufgabe durch einen Wechselrichter mit den Merkmalen des unabhängigen Patentanspruchs 1 gelöst. Bevorzugte Ausführungsformen des neuen Wechselrichters sind in den abhängigen Patentansprüchen definiert.

### BESCHREIBUNG DER ERFINDUNG

Bei dem neuen Wechselrichter sind in dem Gehäuse beiderseits des Kühlluftkanals auf seiner Rückseite Aufnahmen für einzelne große elektrische Bauteile ausgebildet, die in mindestens drei Richtungen durch die Außenwände des Gehäuses aus Metall begrenzt sind. Die großen elektrischen Bauteile können ihre Abwärme damit in den mindestens drei Richtungen direkt an die Außenwände des Gehäuses und über diese an die Umgebung des Gehäuses abgeben. Bei den mindestens drei Richtungen handelt es sich in aller Regel um diejenige nach hinten sowie diejenigen zu den beiden Seiten, d. h. zu dem Kühlluftkanal hin und von diesem weg. Die Aufnahmen grenzen also neben dem Kühlluftkanal direkt an die seitlichen äußeren Abmessungen des Gehäuses an. Hinzu kommen kann eine Begrenzung der Aufnahme durch eine Außenwand des Gehäuses in einer Richtung parallel zu dem Kühlluftkanal, wo die jeweilige Aufnahme dann auch an die vertikalen äußeren Abmessungen des Gehäuses angrenzt. Bei Aufnahmen für Wickelkörper ohne Kern kann weiterhin ein zentraler Lagerdom aus nichtmagnetischem Metall vorgesehen sein, der sich an deren Innenoberfläche anlegt. Insgesamt wird bei dem neuen Wechselrichter sogar eine bessere Kühlung des jeweiligen großen elektrischen Bauteils durch die Umgebungsluft erzielt, als wenn dieses Bauteil außen an dem Gehäuse angebracht wäre, weil die Oberfläche, über die die Abwärme an die Umgebung abgegeben werden kann, durch das Gehäuse stark vergrößert ist. Im Übrigen weist das Gehäuse des neuen Wechselrichters insoweit Minimalabmessungen in seitlicher Richtung auf, als dass es auf beiden Seiten des Kühlkanals nur so breit ist, wie es für die umschließende Aufnahme der großen elektrischen Bauteile unbedingt erforderlich ist. Hinsichtlich der Bautiefe des neuen Wechselrichters stellt die Anordnung der großen elektrischen Bauteile auf beiden Seiten des Kühlluftkanals ebenfalls einen Vorteil dar, indem der hier vorhandene Platz maximal ausgenutzt wird.

Bei den großen elektrischen Bauteilen des neuen Wechselrichters handelt es sich um Wickelkörper, d. h. Spulen, einerseits und Kondensatoren, häufig Elektrolytkondensatoren, d. h. so genannte Elkos, andererseits. Kondensatoren dürfen das Gehäuse des Wechselrichters nicht berühren, sondern müssen einen definierten Abstand hierzu einhalten. Aber auch bei ihnen erweist es sich als günstig, wenn sie in mindestens drei Richtungen durch Außenwände des Gehäuses aus Metall umgeben sind, um die in ihnen generierte Abwärme abzuführen. An Wickelkörper mit üblicher elektrischer Isolation werden die die Aufnahmen begrenzenden Außenwände aus Metall hingegen unmittelbar angeformt, so dass sie an den Wickelkörpern anliegen und die darin generierte Abwärme direkt übernehmen.

Leistungselektronische Bauteile des neuen Wechselrichters, in denen viel Abwärme anfällt, werden in dem Gehäuse an einer Außenwand aus Metall angebracht, die mit ihrer Rückseite den Grund des Kühlluftkanals ausbildet. Hier ist die zu erwartende Kühlleistung durch die Umgebungsluft auf der anderen Rückseite der Außenwand maximal. Zudem wird durch einen relativ hohen Wärmeeintrag am Grund des Kühlluftkanals in maximaler Weise darauf hingewirkt, dass sich in dem Kühlluftkanal durch die darin erwärmte Umgebungsluft ein Kamineffekt ausbildet, der auch ohne ein Gebläse eine Strömung der Umgebungsluft durch den Kühlluftkanal hervorruft.

Um die von den leistungselektronischen Bauteilen generierte Abwärme möglichst stark zu spreizen, weist die Außenwand des Gehäuses des neuen Wechselrichters hinter den leistungselektronischen Bauteilen vorzugsweise eine gegenüber anderen Bereichen des Gehäuses erhöhte Wandstärke auf und/oder ist hier auf der Rückseite des Gehäuses gezielt mit Kühlrippen versehen.

Um den Wärmeübergang von diesen Bauteilen auf die angrenzenden Teile des Gehäuses zu optimieren, sind bei dem neuen Wechselrichter sowohl die Wickelkörper als auch die leistungselektronischen Bauteile an das Gehäuse angeschraubt, um sie an die jeweiligen Außenwände des Gehäuses anzudrücken. Dabei kann der Wärmeübertrag zusätzlich durch dazwischen aufgebrachte Wärmeleitpaste gefördert werden. Während die Wickelkörper einzeln an das Gehäuse angeschraubt werden, werden die leistungselektronischen Bauteile wegen der größeren Anzahl ihrer Anschlusskontakte mit einer sie elektrisch kontaktierenden Hauptplatine des Wechselrichters an das Gehäuse angeschraubt. Hierdurch wird auch die Hauptplatine in dem Gehäuse festgelegt.

Eine solche, die großen elektrischen Bauteile und die leistungselektronischen Bauteile kontaktierende Hauptplatine des neuen Wechselrichters ist mit ihrer Oberseite nach hinten in dem Gehäuse ausgerichtet. Dabei sind zwischen dieser Hauptplatine und allen einzeln mit dem Gehäuse verschraubten Bauteilen Steckkontakte ausgebildet. Das heißt, die Hauptplatine wird an diese Bauteile nicht angelötet, sondern über Steckkontakte verbunden.

Die die großen elektrischen Bauteile und die leistungselektronischen Bauteile kontaktierende Hauptplatine kann bei dem neuen Wechselrichter in ihrer Haupterstreckungsebene den gesamten freien Innenquerschnitt des Gehäuses überspannen, der neben etwaigen großen Wickelkörpern verbleibt, die die gesamte Gehäusetiefe in Anspruch nehmen. Von derartigen großen Wickelkörpern gibt es bei dem neuen Wechselrichter in der Regel jedoch maximal einen.

Prüfmesspunkte, die an der in dem Gehäuse nach vorne ausgerichteten Unterseite der Hauptplatine vorgesehen sind, sind bei dem neuen Wechselrichter ebenso wie Verschraubungspunkte für die Hauptplatine sehr leicht zugänglich. Weder Messsonden noch Schraubwerkzeugen sind irgendwelche von der Unterseite der Hauptplatine abstehende hohe Bauteile im Weg.

Auch für eine Steuerplatine, die zusätzlich zu der Hauptplatine in dem Gehäuse des neuen Wechselrichters angeordnet werden kann, ist viel Platz. Diese Steuerplatine wird vorzugsweise mit ihrer Oberseite nach vorne in dem Gehäuse angeordnet und mit der Hauptplatine über eine oder mehrere Steckkontaktleisten elektrisch verbunden. Dies kann auch die einzige Befestigung der Steuerplatine in dem Gehäuse sein, wenn sie beispielsweise von einem Deckel des Gehäuses in den Steckkontaktleisten gehalten wird. In einem solchen Deckel kann dabei ein Sichtfenster vorgesehen sein, durch das ein Display auf der Steuerplatine sichtbar ist.

Die beiden Platinen sind vorzugsweise nur an ihrer jeweiligen Oberseite mit bedrahteten Bauteilen bestückt. Die Lage dieser bedrahteten Bauteile definiert umgekehrt die Oberseite der jeweiligen Platine. An der Unterseite beider Platinen können jedoch ohne weiteres sogenannte SMD (Surface Mount Devices) oder irgendwelche eingepressten Bauteile, wie beispielsweise Kontaktstecker vorgesehen sein.

Bei dem neuen Wechselrichter ist zumindest ein den Kühlkanal, die Kühlrippen und die Aufnahmen für die großen elektrischen Bauteile umfassender hinterer Gehäuseteil des Gehäuses einstückig aus Metall formgegossen. Auf diese Weise kann die komplexe Ausgestaltung des Gehäuses in diesem Bereich in einer Großserie ökonomisch bereitgestellt werden. Besonders bevorzugt ist es, wenn zumindest dieser Gehäuseteil aus einer Aluminiumdruckgusslegierung besteht, die nichtmagnetisch ist. Auch der vorne liegende Deckel des Gehäuses kann aus einer solchen Aluminiumdruckgusslegierung ausgebildet sein.

Wie bereits angedeutet wurde, verläuft der Kühlkanal bei dem neuen Wechselrichter vorzugsweise vertikal und auch geradlinig, um die Ausbildung eines Kamineffekts durch die darin erwärmte Luft ausnutzen zu können. Die Durchströmung des Kühlkanals kann aber durch ein Gebläse unterstützt werden, das Umgebungsluft in den Kühlkanal einbläst.

Zur Montage des neuen Wechselrichters kann sein Gehäuse in eine Montagewanne einhängbar sein, an der elektrische Anschlüsse für den Wechselrichter an die Gleichstromquelle und das Wechselstromnetz vorgesehen sind. Eine solche Montagewanne erleichtert die seitliche Montage an vertikalen Ständern, und ihre Rückwand kann oberhalb und unterhalb des Gehäuses Luftzuführtaschen ausbilden. Wenn die obere Luftzuführtasche nach oben und/oder die untere Luftzuführtasche nach unten flach ausläuft, werden an den vertikalen Enden der Montagewanne Verwirbelungen der Umgebungsluft vermieden, die als Kühlluft insbesondere durch den Kühlluftkanal zwischen dem Gehäuse des Wechselrichters und der Rückwand der Montagewanne hindurch geführt wird. Zur optischen Verkleidung der Montagewanne kann eine Abdeckung vorgesehen sein, die eine Ausnehmung für den Wechselrichter und Luftzuführöffnungen im Bereich der unteren Luftzuführtasche sowie Luftabführöffnungen im Bereich der oberen Luftzuführtasche aufweist. Vorzugsweise besteht die Montagewanne aus Metall, wie beispielsweise Metallblech. Aus diesem Material kann auch ihre Abdeckung ausgebildet sein.

Vorteilhafte Weiterbildungen der Erfindung ergeben sich aus den Patentansprüchen, der Beschreibung und den Zeichnungen. Die in der Beschreibungseinleitung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche ist ebenfalls möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden.

### KURZBESCHREIBUNG DER FIGUREN

Die Erfindung wird im Folgenden anhand eines konkreten Ausführungsbeispiels des neuen Wechselrichters unter Bezugnahme auf die beigefügten Zeichnungen näher erläutert und beschrieben.
- **Fig. 1**: ist eine perspektivische Ansicht des neuen Wechselrichters mit geschlossenem Gehäuse schräg von vorne.
- **Fig. 2**: zeigt den neuen Wechselrichter mit geschlossenem Gehäuse schräg von hinten.
- **Fig. 3**: ist ein Blick in das geöffnete Gehäuse des neuen Wechselrichters.
- **Fig. 4**: ist ein vertikaler Längsschnitt durch das geöffnete Gehäuse des neuen Wechselrichters entlang einer Schnittlinie A-A gemäß Fig. 3.
- **Fig. 5**: ist ein horizontaler Längsschnitt durch das geöffnete Gehäuse des neuen Wechselrichters entlang einer Schnittlinie B-B gemäß Fig. 3.
- **Fig. 6**: ist ein vertikaler Längsschnitt durch das Gehäuse des neuen Wechselrichters längs einer Schnittebene, die hinter der Zeichenebene von Fig. 3 liegt, mit Blick auf die großen elektrischen und elektronischen Bauteile des Wechselrichters.
- **Fig. 7**: zeigt eine Montagewanne zur Montage des Wechselrichters gemäß den Fig. 1 und 2.
- **Fig. 8**: zeigt den mithilfe der Montagewanne gemäß Fig. 7 in einer Wand aus beplankten Ständern montierten Wechselrichter gemäß den Fig. 1 und 2.
- **Fig. 9**: zeigt den gemäß Fig. 7 in der Wand montierten Wechselrichter nach Verkleidung der Montagewanne mit einer den Wechselrichter freilassenden Abdeckung.

### FIGURENBESCHREIBUNG

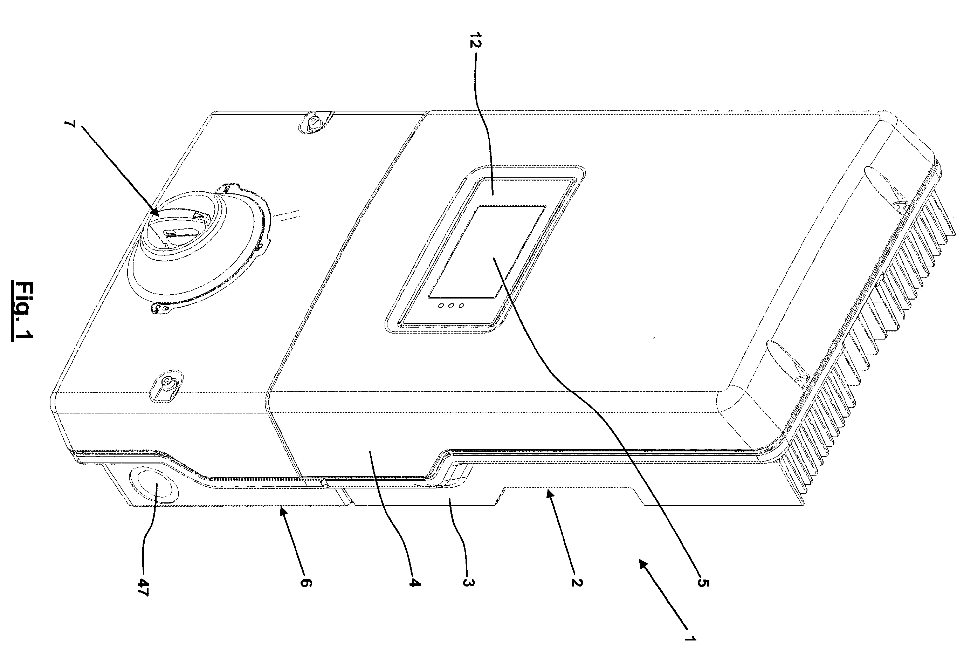

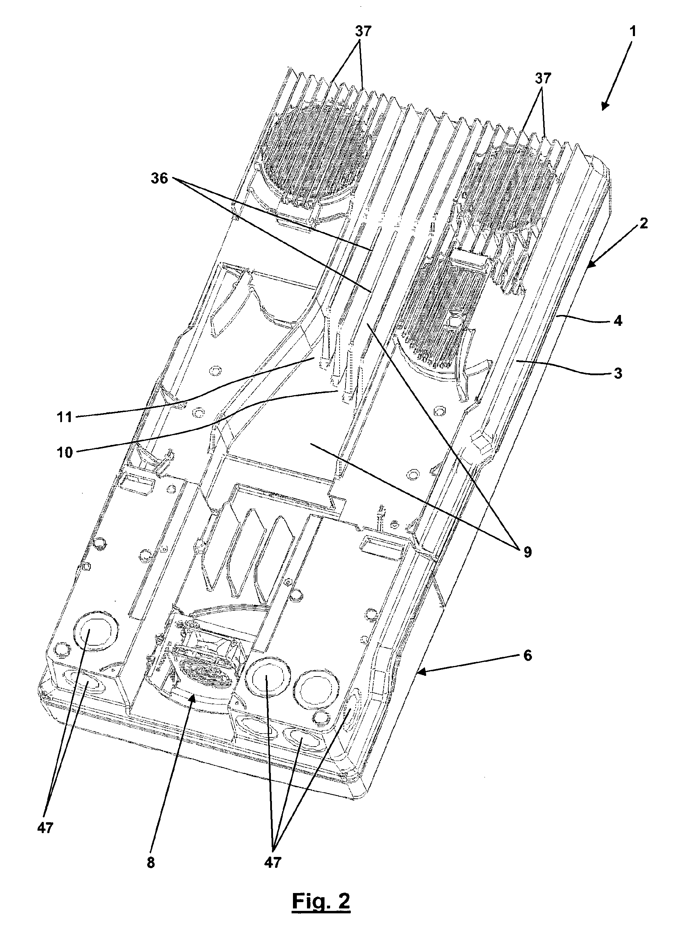

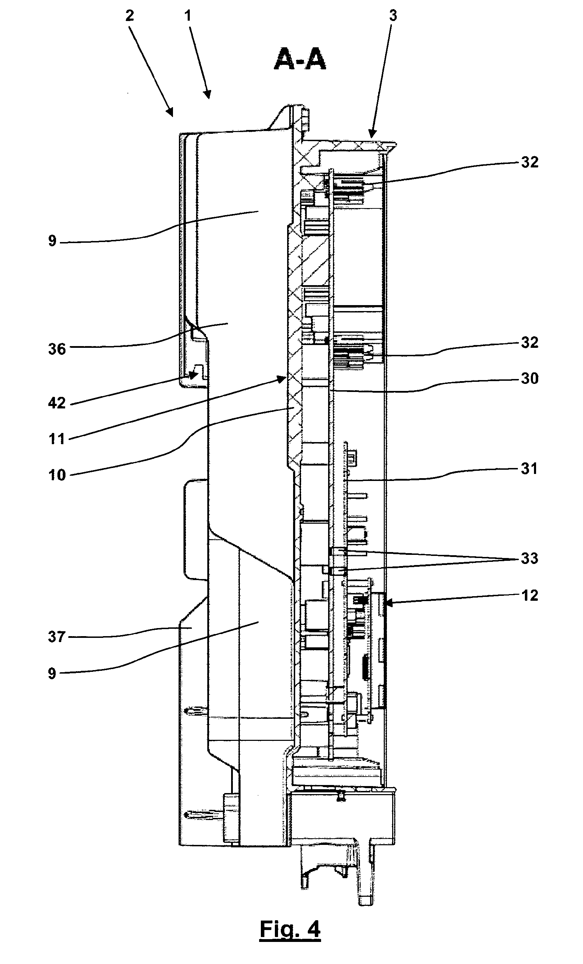

Der in den **Fig. 1** **und** **2** als Ganzes dargestellte Wechselrichter 1 ist zur Einspeisung von elektrischer Energie von einer Gleichstromquelle in ein Stromnetz vorgesehen und weist ein Gehäuse 2 auf. Das Gehäuse 2 umfasst einen hinteren Gehäuseteil 3, der die wesentlichen elektrischen und elektronischen Bauteile des Wechselrichters aufnimmt, und einen Deckel 4, der das Gehäuseteil 3 nach vorne verschließt und in dem ein Sichtfenster 5 ausgebildet ist. Der Deckel 4, bis auf das Sichtfenster 5, und das Gehäuseteil 3 sind jeweils aus einer Aluminiumdruckgusslegierung ausgebildet und schließen so die elektrischen und elektronischen Bauteile des Wechselrichters 1 in einer nichtmagnetischen metallischen Umhüllung ein. Angesetzt an das Gehäuse 2 ist eine Baueinheit 6, die als von außen sichtbare Bauteile des Wechselrichters 1 einen DC-Lasttrenner 7 und ein optionales Gebläse 8 umfasst. Der DC-Lasttrennner 7 erlaubt ein sicheres Abtrennen des Wechselrichters 1 von einer angeschlossenen Gleichstromquelle. Das Gebläse 8 dient dazu, einen an der Rückseite des Gehäuses 2 ausgebildeten vertikalen Kühlluftkanal 9 von unten mit Umgebungsluft als Kühlluft zu beaufschlagen. Dieses Gebläse 8 ist bei größerer Leistung des Wechselrichters 1 und entsprechend auch größerer absoluter Verlustleistung sinnvoll, um die aus der Verlustleistung resultierende Abwärme sicher von dem Gehäuse 2 abzuführen. Bei kleinerer Einspeiseleistung reicht zur Kühlung des Gehäuses 2 auch ein sich in dem Kühlluftkanal 9 ausbildender Kamineffekt aus, weil die höchsten Temperaturen an Außenwänden des Gehäuses 2 an der Außenwand 10 am Grund 11 des Kühlluftkanals 9 erreicht werden, worauf im Zusammenhang mit Fig. 4 noch näher eingegangen werden wird. Über die Baueinheit 6 wird der Wechselrichter 1 an die Gleichstromquelle und das Wechselstromnetz angeschlossen. Die Baueinheit weist dazu vorbereitete Öffnungen 47 für die Durchführung von elektrischen Anschlussleitungen auf. Das Gehäuse 2 und die Baueinheit 6 sind insgesamt so schmal, dass der Wechselrichter 1 zwischen zwei Ständern einer Wand eines Hauses aus beplankten Ständern, wie sie in Nordamerika üblich ist, angeordnet werden kann. Auch die Tiefe des Gehäuses 1 und der Baueinheit 6 ist von der Größenordnung der typischen Tiefe derartiger Wände. Von den Bauteilen im Inneren des Gehäuses 2 zeigt Fig. 1 nur ein Display 12 hinter dem Sichtfenster 5.

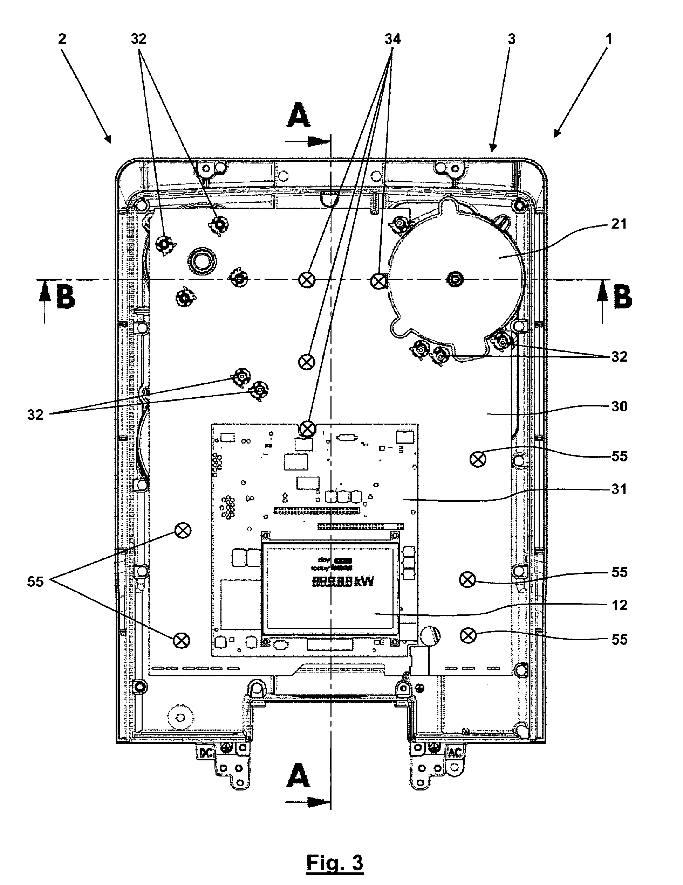

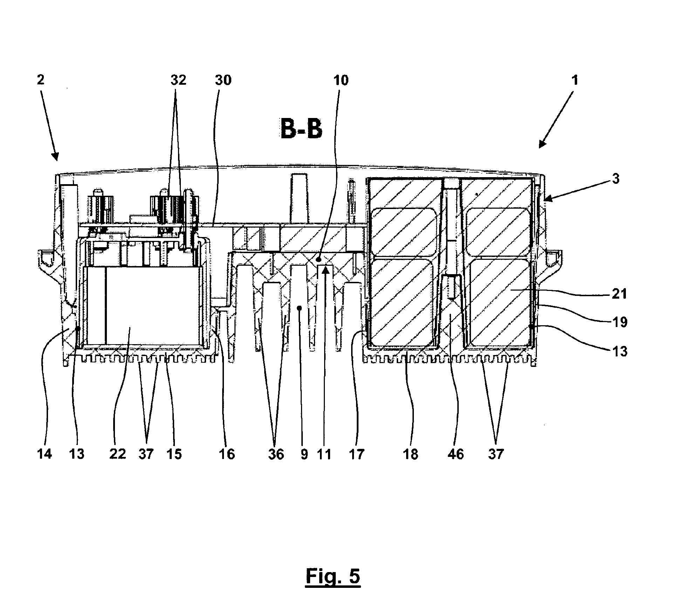

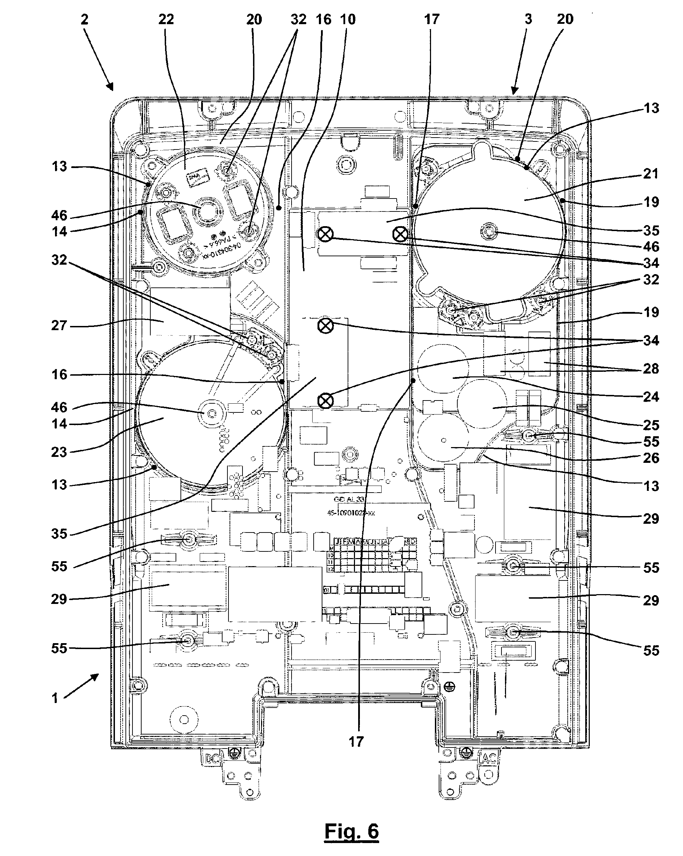

Weitere Bauteile des Wechselrichters 1 sind nur aus der Draufsicht gemäß **Fig. 3** und den Schnitten der **Fig. 4 bis 6** ersichtlich. Aus diesen Darstellungen geht hervor, dass der hintere Gehäuseteil 3 im Inneren des Gehäuses 2 auf beiden Seiten des Kühlluftkanals 9 Aufnahmen 13 für große elektrische Bauteile des Wechselrichters 1 ausbildet, die in mindestens drei Richtungen durch Außenwände 14 bis 20 des Gehäuses 1 begrenzt sind, so dass die Abwärme von den in den Aufnahmen 13 angeordneten großen elektrischen Bauteilen über diese Außenwände 14 bis 20 hinweg direkt an die Umgebung des Wechselrichters 1 abgegeben werden kann. Dabei stehen große elektrische Bauteile in Form von Wickelkörpern 21 bis 23 direkt mit den Außenwänden 14 bis 20 des Gehäuses 1 in Kontakt, und sie sind an den Gehäuseteil 2 fest angeschraubt. Die Wickelkörper 21 bis 23 mit Ringkern sind dabei auf einem Lagerdom 46 angeordnet, der von dem Gehäuseteil 3 absteht und Teil desselben ist. Große elektrische Bauteile des Wechselrichters 1 in Form von Elektrolytkondensatoren 24 bis 26 und eines Filmkondensators 27 ragen indes in die entsprechenden Aufnahmen 13 nur hinein, ohne die angrenzenden Außenwände 14 bis 20 zu berühren. Die Kondensatoren 24 bis 27 sind an einer in Fig. 6 weggeschnittenen Hauptplatine 30 des Wechselrichters 1 gelagert, die mit ihrer mit bedrahteten Bauteilen bestückten Oberseite nach hinten in dem Gehäuse 2 ausgerichtet ist, so dass in Fig. 3 nur ihre allenfalls mit SMDs und eingepressten Bauteilen bestückte Unterseite zu sehen ist. Die an den Gehäuseteil 3 angeschraubten Wickelkörper 21 bis 23 kontaktiert die Hauptplatine 30 über Steckkontakte 32, die beim Einsetzen der Hauptplatine 30 in das Gehäuse geschlossen werden. Die Steckkontakte dienen auch zur Befestigung der Hauptplatine 30 in dem oberen Bereich des Gehäuseteils 3. Im unteren Bereich des Gehäuseteils 3 ist die Hauptplatine 30 mit Schrauben 55 befestigt. Fig. 6 zeigt als weitere größere elektrische Bauteile des Wechselrichters 1 Relais 28 und EMV-Drosseln 29. Fig. 3 lässt erkennen, dass die Hauptplatine 30 in ihrer Haupterstreckungsebene zwar bis auf den Bereich des sehr hohen Wickelkörpers 21 den gesamten freien vertikalen Querschnitt des Gehäuses 2 überspannt, dass sie aber im vorderen Bereich des Gehäuseteils 3 viel Raum für eine Steuerplatine 31 lässt, die über Steckkontaktleisten 33 mit der Hauptplatine 30 mechanisch und elektrisch verbunden ist und die in ihrer Stellung von dem Deckel 4 gemäß den Fig. 1 und 2 gesichert werden kann. Auf der Steuerplatine 31 ist das Display 12 vorgesehen. Die Steuerplatine 31 zeigt mit ihrer Oberseite nach vorne. Die Platinen 30, 31 liegen so einander mit ihren Rückseiten unter Zwischenordnung der Steckkontaktleisten 33 gegenüber. An der Rückseite der Hauptplatine 30 liegende Prüfmesspunkte sind zu Prüfzwecken ebenso leicht erreichbar, wie die Schrauben 55, über die die Hauptplatine 30 an dem Gehäuseteil 3 festgeschraubt ist. Weitere gut zugängliche Schrauben 34 sind neben leistungselektronischen Bauteilen 35 z. B. in Form von Schaltermodulen für Wechselrichterbrücken des Wechselrichters 1 angeordnet, um diese an die Hauptplatine 30 angelöteten leistungselektronischen Bauteile 35 zwecks guter thermischer Ankopplung von innen fest an die Außenwand 10 des Gehäuses 2 anzudrücken, die auf ihrer anderen Seite den Grund 11 des Kühlkanals 9 ausbildet. Zwischen den leistungselektronischen Bauteilen 35 und der zur besseren Wärmespreizung dicker ausgebildeten Außenwand 10 kann eine zusätzliche Schicht aus Wärmeleitpaste vorgesehen sein. In dem sich geradlinig vertikal und mittig über die Rückseite des Gehäuses 1 erstreckenden Kühlkanal 9 sind im oberen Bereich und speziell von der Gehäusewand 10 hinter den leistungselektronischen Bauteilen 35 abgehend Kühlrippen 36 vorgesehen. Weitere, zum Teil kürzere Kühlrippen 37 vergrößern die gesamte Wärme abstrahlende Oberfläche an der Rückseite des Gehäuses 1.

Bei dem neuen Wechselrichter 1 ist das gesamte von seinem Gehäuse 2 überspannte Volumen einschließlich des Kühlluftkanals 9 voll ausgenutzt. Das innerhalb des Gehäuses 2 verbleibende freie Volumen ist im Wesentlichen notwendig, um die erforderlichen Abstände von darin enthaltenen elektrischen Bauteilen untereinander und zu dem Gehäuse 2 einzuhalten. Der verbleibende Freiraum im vorderen Bereich des Gehäuses 2 kann durch eine im Einzelfall erforderliche größere Steuerplatine 31 ausgenutzt werden.

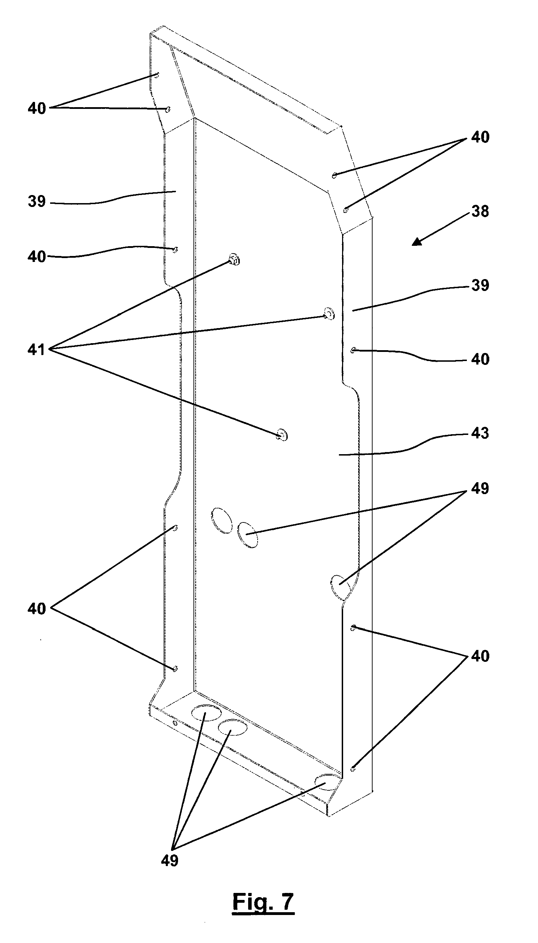

Die in **Fig. 7** gezeigte Montagewanne 38 weist zwei Seitenwände 39 mit Befestigungslöchern 40 zum Befestigen der Montagewanne an zwei Ständern einer Wandkonstruktion nach nordamerikanischem Muster auf. Die Montagewanne kommt dabei zwischen den Ständern zur Anordnung und nimmt den Wechselrichter 1 auf, wobei sie ihn über eine hier nicht dargestellte Anhängeeinrichtung abstützt, für die an der Montagewanne 38 Gewindebolzen 41 vorgesehen sind und an der Rückseite des Wechselrichters 1 ein komplementärer Aufhängehaken 42 (siehe Fig. 4) ausgebildet ist. Der Wechselrichter 1 hängt so an der Rückwand 43 der Montagewanne an, wobei seine Kühlrippen 36 und 37 die Rückwand 43 kontaktieren und der Kühlluftkanal 9 um seine vertikale Haupterstreckungsrichtung herum im Wesentlichen geschlossen ist. An der Montagewanne können elektrische Anschlüsse vorgesehen werden, für die Durchbrechungen 49 vorgesehen sind und an die der Wechselrichter in angehängtem Zustand anschließbar ist.

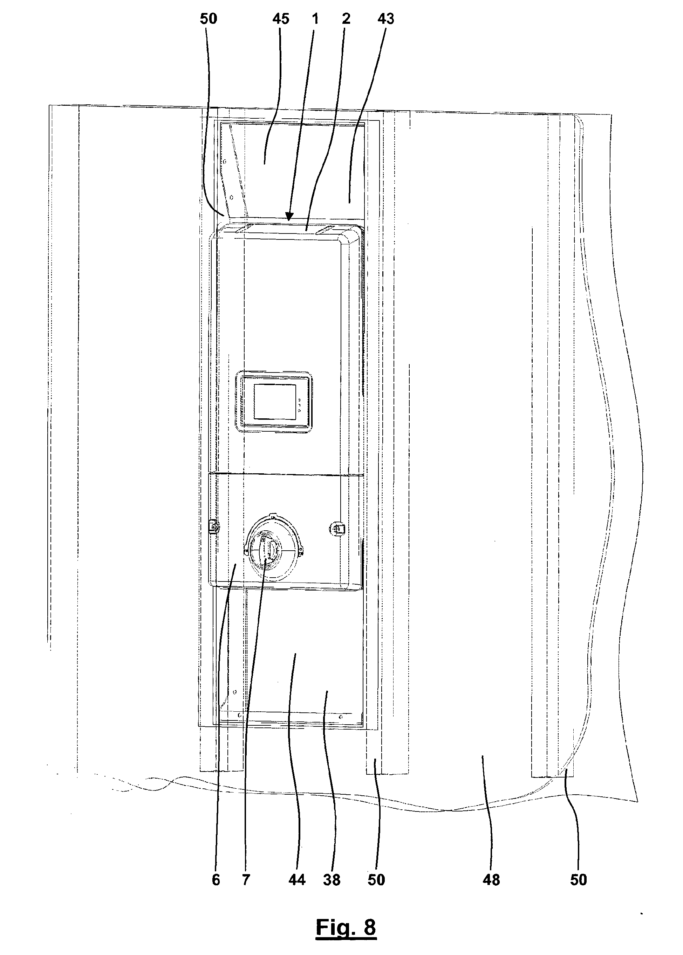

**Fig. 8** zeigt die zwischen zwei Ständern 50 einer Wand 48 aus beplankten Ständern 50 angebrachte Montagewanne 38 mit montiertem Wechselrichter 1. Dort ist zu sehen, dass oberhalb und unterhalb des Wechselrichters 1 in der Montagewanne 38 Luftzuführungstaschen 44 und 45 verbleiben, wobei die obere Luftzuführungstasche 45 nach oben flach ausläuft und in dem Kühlluftkanal 9 aufsteigende erwärmte Umgebungsluft vor die angrenzende Wand 48 lenkt und über die untere Luftzuführungstasche kühle Umgebungsluft in den Kühlluftkanal 9 nachströmt.

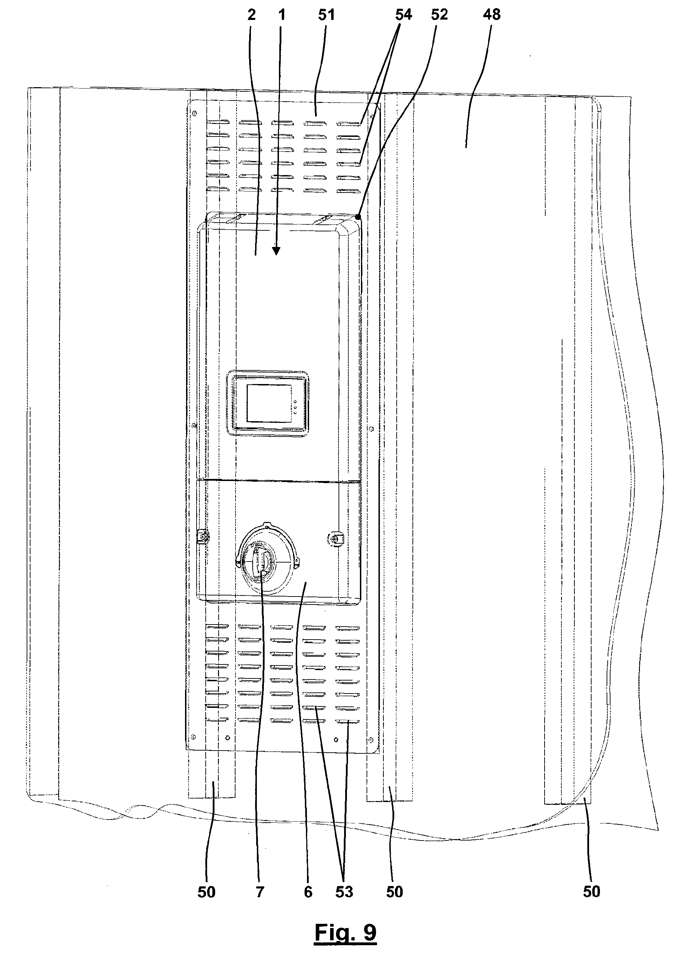

In **Fig. 9** ist die Montagewanne 38 mit einer Abdeckung 51 verkleidet, die mit einer Ausnehmung 52 nur den Wechselrichter 1 freigibt und über den Luftzuführungstaschen 44 und 45 Luftzuführöffnungen 53 bzw. Luftabführöffnungen 54 aufweist. Zumindest im Wesentlichen schließt die Abdeckung 51 nach vorne in derselben Ebene wie die Wand 48 ab.

**BEZUGSZEICHENLISTE**

| | | | |
|---|---|---|---|
| 1 | Wechselrichter | 31 | Steuerplatine |
| 2 | Gehäuse | 32 | Steckkontakt |
| 3 | Gehäuseteil | 33 | Steckkontaktleiste |
| 4 | Deckel | 34 | Schraube |
| 5 | Sichtfenster | 35 | Leistungselektronisches Bauteil |
| 6 | Baueinheit | 36 | Kühlrippe |
| 7 | DC-Lasttrenner | 37 | Kühlrippe |
| 8 | Gebläse | 38 | Montagewanne |
| 9 | Kühlluftkanal | 39 | Seitenwand |
| 10 | Außenwand | 40 | Befestigungsloch |
| 11 | Grund | 41 | Gewindebolzen |
| 12 | Display | 42 | Aufhängehaken |
| 13 | Aufnahme | 43 | Rückwand |
| 14 | Außenwand | 44 | Luftzuführungstasche |
| 15 | Außenwand | 45 | Luftzuführungstasche |
| 16 | Außenwand | 46 | Lagerdom |
| 17 | Außenwand | 47 | Öffnung |
| 18 | Außenwand | 48 | Wand |
| 19 | Außenwand | 49 | Durchbrechung |
| 20 | Außenwand | 50 | Ständer |
| 21 | Wickelkörper | 51 | Abdeckung |
| 22 | Wickelkörper | 52 | Ausnehmung |
| 23 | Wickelkörper | 53 | Luftzuführöffnung |
| 24 | Elektrolytkondensator | 54 | Luftabführöffnung |
| 25 | Elektrolytkondensator | 55 | Schraube |
| 26 | Elektrolytkondensator | | |
| 27 | Folienkondensator | | |
| 28 | Relais | | |
| 29 | EMV-Drossel | | |
| 30 | Hauptplatine | | |

## Patentansprüche

1. Wechselrichter (1) zur Einspeisung elektrischer Energie von einer Gleichstromquelle in ein Wechselstromnetz,
- wobei der Wechselrichter (1) ein Gehäuse (2) und in dem Gehäuse (2) angeordnete elektrische und elektronische Bauteile (21-29; 30; 31; 35) aufweist,
- wobei mittig über die Rückseite des Gehäuses (2) ein Kühlluftkanal (9) mit darin angeordneten in der Längsrichtung des Kühlluftkanals ausgerichteten Kühlrippen (36) verläuft,
- wobei in dem Gehäuse (2) neben dem Kühlluftkanal (9) Aufnahmen (13) für einzelne große elektrische Bauteile (21-29) ausgebildet sind, die in mindestens drei Richtungen durch Außenwände (14-20) des Gehäuses (2) aus Metall begrenzt sind,
- wobei die Außenwände (14-20) an zumindest einige der großen elektrischen Bauteile (21-26) angeformt sind,
- wobei leistungselektronische Bauteile (35) in dem Gehäuse (2) an der Innenseite einer Außenwand (10) des Gehäuses (2) aus Metall anliegen, die mit ihrer Außenseite den Grund (11) des Kühlluftkanals (9) ausbildet,
- wobei eine die großen elektrischen Bauteile und die leistungselektronischen Bauteile kontaktierende Hauptplatine (30) in dem Gehäuse (2) mit ihrer Oberseite nach hinten ausgerichtet ist, und
- die leistungselektronischen Bauteile an die Hauptplatine (30) angelötet sind,
**dadurch gekennzeichnet,**
- **dass** die Aufnahmen (13) für die einzelnen großen elektrischen Bauteile (21-29) beiderseits des über die Rückseite des Gehäuses (2) verlaufenden Kühlluftkanals (9) ausgebildet sind,
- **dass** einige der großen elektrischen Bauteile Wickelkörper (21-23) sind und die Außenwände (14-20) in den Aufnahmen für die Wickelkörper (21-23) zumindest bereichsweise an den Wickelkörpern (21-23) anliegen,
- wobei die Wickelkörper (21-23) einzeln an das Gehäuse (2) angeschraubt sind und wobei zwischen der Hauptplatine (30) und den mit dem Gehäuse (2) verschraubten Wickelkörpern (21-23) Steckkontakte (32) ausgebildet sind, und
- **dass** die an die Hauptplatine (30) angelöteten leistungselektronischen Bauteile (35) mit der Hauptplatine (30) an das Gehäuse (2) angeschraubt sind, um sie an die Außenwand (10) des Gehäuses (2) anzudrücken.

2. Wechselrichter (1) nach Anspruch 1, **dadurch gekennzeichnet, dass** die Außenwand (10) zwischen den leistungselektronischen Bauteilen (35) und dem Grund (11) des Kühlluftkanals (9) eine erhöhte Wandstärke aufweist.

3. Wechselrichter (1) nach Anspruch 1 oder 2, **dadurch gekennzeichnet, dass** die Außenwand (10) an dem Grund (11) des Kühlluftkanals (9) mit den Kühlrippen (36) versehen ist.

4. Wechselrichter (1) nach einem der Ansprüche 1 bis 3, **dadurch gekennzeichnet, dass** zumindest einige der großen elektrischen Bauteile (21 bis 23) und/oder die leistungselektronischen Bauteile (35) unter Zwischenordnung von Wärmeleitpaste an das Gehäuse (2) angeschraubt sind.

5. Wechselrichter (1) nach einem der Ansprüche 1 bis 4, **dadurch gekennzeichnet, dass** die Hauptplatine (30) in ihrer Haupterstreckungsebene den freien Innenquerschnitt des Gehäuses (2) überspannt.

6. Wechselrichter (1) nach einem der Ansprüche 1 bis 5, **dadurch gekennzeichnet, dass** eine Steuerplatine (31) in dem Gehäuse (2) mit ihrer Oberseite nach vorne ausgerichtet ist.

7. Wechselrichter (1) nach Anspruch 6, **dadurch gekennzeichnet, dass** die Platinen (30, 31) nur an ihren Oberseiten mit bedrahteten Bauteilen bestückt sind.

8. Wechselrichter (1) nach Anspruch 6 oder 7, **dadurch gekennzeichnet, dass** zwischen der Hauptplatine (30) und der Steuerplatine (31) mindestens eine Steckkontaktleiste (33) vorgesehen ist.

9. Wechselrichter (1) nach einem der Ansprüche 1 bis 8, **dadurch gekennzeichnet, dass** zumindest ein den Kühlkanal (9), die Kühlrippen (36) und die Aufnahmen (13) umfassender hinterer Gehäuseteil (3) des Gehäuses (2) einstückig aus Metall formgegossen ist.

10. Wechselrichter (1) nach Anspruch 9, **dadurch gekennzeichnet, dass** zumindest der hintere Gehäuseteil (3) aus einer Aluminiumdruckgusslegierung besteht.

11. Wechselrichter (1) nach einem der Ansprüche 1 bis 10, **dadurch gekennzeichnet, dass** der Kühlluftkanal (9) vertikal ausgerichtet ist, wobei optional ein Gebläse (8) Umgebungsluft von unten in den Kühlluftkanal (9) einbläst.

12. Wechselrichter (1) nach einem der Ansprüche 1 bis 11, **dadurch gekennzeichnet, dass** das Gehäuse (2) in eine Montagewanne (38) einhängbar ist, an der elektrische Anschlüsse für den Wechselrichter (1) an die Gleichstromquelle und das Wechselstromnetz vorgesehen sind, die zur seitlichen Montage an vertikalen Ständern vorgesehen ist und deren Rückwand (43) oberhalb und unterhalb des Gehäuses (2) des Wechselrichters (1) Luftzuführungstaschen (44, 45) ausbildet.

## Claims

1. Inverter (1) for feeding electric energy from a DC source into an AC grid,
- wherein the inverter (1) has a housing (2) and electric and electronic parts (21-29; 30; 31; 35) arranged within the housing (2),
- wherein a cooling air channel (9) with cooling fins (36) aligned along the longitudinal direction of the cooling channel arranged therein runs centrally across the backside of the housing (2),
- wherein adjacent to the cooling air channel (9) receptacles (13) for individual large electric parts (21-29) are formed in the housing (2), the receptacles (13), in at least three directions, being delimited by outer walls (14-20) of the housing (2) made of metal,
- wherein the outer walls (14-20) are form-adapted to at least some of the large electric parts (21-26),
- wherein power electronic parts (35) in the housing (2) rest against the inside of an outer wall (10) of the housing (2) made of metal, which, with its outside, forms the base (11) of the cooling air channel (9),
- wherein a main printed circuit board (30) contacting the large electric parts and the power electronic parts is oriented with its upside pointing backwards within the housing (2), and
- wherein the power electronic parts are soldered to the main printed circuit board (30), **characterised in**
- **that** the receptacles (13) for the individual large electric parts (21-29) are formed on both sides of the cooling air channel (9) running across the backside of the housing (2),
- **that** some of the large electric parts are coil forms (21-23) and that the outer wall (14-20) in the receptacles for the coil forms (21-23) at least partially abut against the coil forms (21-23),
- wherein the coil forms (21-23) are individually screwed to the housing (2), and wherein plug-in contacts (32) are formed between the main printed circuit board (30) and the coil forms (21-23) screwed to the housing (2), and
- **that** the power electronic parts (35) soldered to the main printed circuit board (30) are screwed to the housing (2) to press them against the outer wall (10) of the housing (2).

2. Inverter (1) of claim 1, **characterised in that** the outer wall (10) has an increased wall thickness between the power electronic parts (35) and the base (11) of the cooling air channel (9).

3. Inverter (1) of claim 1 or 2, **characterised in that** the outer wall (10) at the base (11) of the cooling air channel (9) is provided with cooling fins (36).

4. Inverter (1) of any of the claims 1 to 3, **characterised in that** at least some of the large electric parts (21 to 23) and/or the power electronic parts (35) are screwed to the housing (2) with heat transfer paste arranged in between.

5. Inverter (1) of any of the claims 1 to 4, **characterised in that** the main printed circuit board (30) in its plane of main extension covers the free cross-section of the housing (2).

6. Inverter (1) of any of the claims 1 to 5, **characterised in that** a control printed circuit board (31) is arranged in the housing (2) with its upside pointing forwards.

7. Inverter (1) of claim 6, **characterised in that** the printed circuit boards (30, 31) are provided with wired parts at their upsides only.

8. Inverter (1) of claim 6 or 7, **characterised in that** at least one multipoint connector (33) is provided between the main printed circuit board (30) and the control printed circuit board (31).

9. Inverter (1) of any of the claims 1 to 8, **characterised in that** at least one back housing part (3) of the housing (2) including the cooling channel (9), the cooling fins (36) and the receptacles (13) is form-moulded of metal.

10. Inverter (1) of claim 9, **characterised in that** at least the back housing part (3) consists of a diecast aluminium alloy.

11. Inverter (1) of any of the claims 1 to 10, **characterised in that** the cooling air channel (9) is oriented vertically, wherein, optionally, a fan (8) blows air out of the surroundings into the cooling air channel (9) from beneath.

12. Inverter (1) of any of the claims 1 to 11, **characterised in that** the housing (2) is mountable within a mounting tray (38) at which connections for the inverter (1) to the DC source and to the AC grid are provided, which is provided for laterally mounting to vertical posts, and whose back wall (43) forms air-guiding pockets (44, 45) above and below the housing (2) of the inverter (1).

## Revendications

1. Onduleur (1) pour alimenter un réseau de courant alternatif en énergie électrique fournie par une source de courant continu,
- l'onduleur (1) comportant un boîtier (2) et des composants électriques et électroniques (21-29; 30; 31; 35) disposés dans ledit boîtier (2),
- un conduit d'air froid (9) avec des ailettes de refroidissement (36), disposées dans celui-ci et orientées dans le sens longitudinal dudit conduit d'air froid, s'étendant au milieu sur la face arrière du boîtier (2),
- des logements (13) pour de grands composants électriques (21-29) individuels étant réalisés dans le boîtier (2) à côté du conduit d'air froid (9) et étant délimités dans au moins trois directions par des parois extérieures (14-20) du boîtier (2) en métal,
- lesdites parois extérieures (14-20) étant formées contre au moins quelques-uns des grands composants électriques (21-26),
- des composants électroniques de puissance (35) étant en appui dans le boîtier (2) contre la face intérieure d'une paroi extérieure (10) du boîtier (2) en métal, laquelle forme, avec sa face extérieure, le fond (11) du conduit d'air froid (9),
- une platine principale (30), qui contacte les grands composants électriques et les composants électroniques de puissance, étant orientée dans le boîtier (2) avec sa face supérieure vers l'arrière, et
- les composants électroniques de puissance étant brasés contre la platine principale (30),
**caractérisé**
- **en ce que** les logements (13) pour les grands composants électriques (21-29) individuels sont réalisés de part et d'autre du conduit d'air froid (9) s'étendant sur la face arrière du boîtier (2),
- **en ce que** les grands composants électriques sont des corps de bobine (21-23) et les parois extérieures (14-20) dans les logements pour les corps de bobines (21-23) sont en appui au moins par zones contre les corps de bobines (21-23),
- lesdits corps de bobine (21-23) étant vissés individuellement contre le boîtier (2), et des contacts mâles (32) étant réalisés entre la platine principale (30) et les corps de bobine (21-23) vissés sur le boîtier (2), et
- **en ce que** les composants électroniques de puissance (35) brasés contre la platine principale (30) sont vissés, conjointement avec la platine principale (30), sur le boîtier (2) afin de les presser contre la paroi extérieure (10) du boîtier (2).

2. Onduleur (1) selon la revendication 1, **caractérisé en ce que** la paroi extérieure (10) comporte une plus grande épaisseur de paroi entre les composants électroniques de puissance (35) et le fond (11) du conduit d'air froid (9).

3. Onduleur (1) selon la revendication 1 ou 2, **caractérisé en ce que** la paroi extérieure (10) au niveau du fond (11) du conduit d'air froid (9) est munie d'ailettes de refroidissement (36).

4. Onduleur (1) selon l'une quelconque des revendications 1 à 3, **caractérisé en ce qu'**au moins quelques-uns des grands composants électriques (21 à 23) et/ou les composants électroniques de puissance (35) sont vissés contre le boîtier (2) en intercalant une pâte thermoconductrice.

5. Onduleur (1) selon l'une quelconque des revendications 1 à 4, **caractérisé en ce que** la platine principale (30) dans son plan d'extension principal s'étend sur toute la section libre intérieure du boîtier (2).

6. Onduleur (1) selon l'une quelconque des revendications 1 à 5, **caractérisé en ce qu'**une platine de commande (31) est orientée dans le boîtier (2) avec sa face supérieure vers l'avant.

7. Onduleur (1) selon la revendication 6, **caractérisé en ce que** les platines (30, 31) sont munies de composants câblés uniquement sur leurs faces supérieures.

8. Onduleur (1) selon la revendication 6 ou 7, **caractérisé en ce qu'**au moins une réglette de contacts mâles (33) est prévue entre la platine principale (30) et la platine de commande (31).

9. Onduleur (1) selon l'une quelconque des revendications 1 à 8, **caractérisé en ce qu'**au moins une partie arrière (3) du boîtier (2), qui comporte le conduit d'air froid (9), les ailettes de refroidissement (36) et les logements (13), est moulée en métal d'un seul tenant.

10. Onduleur (1) selon la revendication 9, **caractérisé en ce qu'**au moins la partie arrière (3) du boîtier est réalisée dans un alliage d'aluminium coulé sous pression.

11. Onduleur (1) selon l'une quelconque des revendications 1 à 10, **caractérisé en ce que** le conduit d'air froid (9) est orienté verticalement, une soufflerie (8) insufflant optionnellement de l'air ambiant par le bas dans le conduit d'air froid (9).

12. Onduleur (1) selon l'une quelconque des revendications 1 à 11, **caractérisé en ce que** le boîtier (2) peut être suspendu dans un carter de montage (38), sur lequel sont prévus des raccords électriques pour l'onduleur (1) avec la source de courant continu et le réseau de courant alternatif, lequel est prévu pour un montage latéral sur des montants verticaux et dont la paroi arrière (43) forme des poches d'admission d'air (44, 45) au-dessus et au-dessous du boîtier (2) de l'onduleur (1).
